# FASCICULE DE BREVET EUROPEEN

(11) **EP 3 782 198 B1**
(45) Date de publication et mention de la délivrance du brevet: **26.01.2022**
(21) Numéro de dépôt: 19720512.3
(22) Date de dépôt: 19.04.2019
(51) Int. Cl.: H01L 31/0203, E06B 9/68

(54) **CAPTEUR COMMUNIQUANT POUR UN SYSTÈME DOMOTIQUE ET SYSTÈME DOMOTIQUE COMPRENANT UN TEL CAPTEUR**
KOMMUNIZIERENDER SENSOR FÜR EIN HEIMAUTOMATIONSSYSTEM UND HEIMAUTOMATIONSSYSTEM MIT SOLCH EINEM SENSOR
COMMUNICATING SENSOR FOR A HOME AUTOMATION SYSTEM, AND HOME AUTOMATION SYSTEM COMPRISING SUCH A SENSOR

(30) Priorité: 20.04.2018 FR 1853515
(43) Date de publication de la demande: 24.02.2021
(73) Titulaire: Somfy Activites SA, 74300 Cluses (FR)
(72) Inventeur: CLERY, Sébastien, 74300 Cluses (FR); PREVOTEAU, Mathieu, 74960 Cran-Gevrier (FR)
(74) Mandataire: Lavoix
(86) Numéro de dépôt international: PCT/EP2019/060226
(87) Numéro de publication internationale: WO 2019/202144

(56) Documents cités:
- EP-A1- 1 746 246
- DE-U1- 29 923 046
- FR-A1- 3 050 842

## Description

La présente invention concerne un capteur communiquant pour un système domotique et un système domotique comprenant un tel capteur communiquant.

L'invention est relative au domaine des capteurs utilisés pour la domotique, c'est-à-dire pour l'automatisation d'équipements, préférentiellement pour un domicile d'habitation ou, en variante, pour des locaux professionnels, tels que des bureaux.

On connaît un système domotique comprenant un capteur communiquant, le capteur communiquant étant apte à détecter l'ensoleillement. Ce système domotique comprend également des stores automatiques, disposés dans une pièce, qui, en fonction de l'intensité de l'ensoleillement captée par le capteur communiquant, sont abaissés ou relevés automatiquement. En particulier, au-delà d'un certain seuil d'intensité lumineuse détectée, le capteur communiquant envoie, au moyen d'une communication sans fil, un message aux stores, afin qu'ils soient automatiquement abaissés, pour diminuer la luminosité dans la pièce. Au contraire, en-deçà d'un certain seul d'intensité lumineuse détectée, par exemple lorsqu'un voile nuageux couvre le soleil, le capteur communiquant envoie, au moyen de la communication sans fil, un message aux stores, afin qu'ils soient automatiquement relevés, pour augmenter la luminosité dans la pièce. L'automatisation des stores permet de réguler facilement et automatiquement la température de la pièce, sans faire appel à des moyens de conditionnement de l'air. L'abaissement des stores en cas d'excès de soleil permet de préserver le mobilier des rayons lumineux du soleil.

Un tel capteur est fixé à une vitre d'une fenêtre à l'aide d'une ventouse, montée sur une face avant du capteur. Ce mode de fixation du capteur présente plusieurs inconvénients.

La ventouse présente un certain encombrement et est interposée entre une surface de captage de lumière du capteur et la vitre de la fenêtre, d'où provient la lumière du soleil.

Pour éviter cela, la face avant du capteur doit être suffisamment grande pour que la surface de captage de lumière soit décalée par rapport à la ventouse.

Par ailleurs, ce type de capteur ne rend pas possible la fixation de celui-ci à un mur sans recourir à un support spécifique.

Le document EP1746246A1 divulgue un capteur communiquant connu servant dans le cadre d'un système domotique.

La présente invention a pour but de résoudre les inconvénients précités et de proposer un capteur communiquant pour un système domotique, ainsi qu'un système domotique comprenant un tel capteur communiquant, dont le mode de fixation est plus polyvalent, tout en étant particulièrement compact.

A cet effet, la présente invention vise, selon un premier aspect, un capteur communiquant pour un système domotique, le capteur communiquant comprenant un module principal présentant extérieurement une surface de captage de lumière et embarquant une unité électronique, l'unité électronique étant configurée pour communiquer à distance avec une unité de commande du système domotique.

Selon l'invention, le capteur communiquant comprend, en outre, un support. Le support est séparable du module principal et comprend :
- un élément de fixation du support contre une surface de support, et
- un corps, le corps étant solidaire de l'élément de fixation, le corps comprenant un logement traversant, une ouverture avant et une ouverture arrière, chacune des ouvertures avant et arrière débouchant du corps, à l'opposé l'une de l'autre par rapport au logement traversant ménagé à l'intérieur du corps, l'élément de fixation étant disposé du côté de l'ouverture arrière.

En outre, le logement traversant du corps loge le module principal alternativement selon deux orientations :
- une première orientation, dans laquelle la surface de captage de lumière est encadrée par l'ouverture avant, pour recevoir de la lumière au travers de l'ouverture avant, et
- une deuxième orientation, opposée à la première orientation, dans laquelle la surface de captage de lumière est encadrée par l'ouverture arrière, pour recevoir de la lumière au travers de l'ouverture arrière.

Grâce à l'invention, un même support permet de fixer le module principal selon deux orientations opposées pour la captation de lumière. L'ouverture arrière du support est toujours tournée contre la surface de support à laquelle le support est fixé, du fait que l'élément de fixation est disposé du côté de l'ouverture arrière.

Par conséquent, lorsque la surface de support est transparente, typiquement une vitre d'une fenêtre, le module principal est logé à l'intérieur du logement traversant du corps selon la deuxième orientation, pouvant également être appelée indirecte, de sorte que la surface de captage de lumière du module principal est encadrée par l'ouverture arrière du support et peut ainsi capter la lumière au travers de la surface de support.

Lorsque la surface de support est au contraire opaque, typiquement un mur intérieur ou extérieur d'une habitation ou de locaux de bureaux, le module principal est logé à l'intérieur du logement traversant du corps selon la première orientation, pouvant également être appelée directe, de sorte que la surface de captage de lumière du module principal est encadrée par l'ouverture avant du support, dirigée à l'opposé de la surface de support.

Le même support du capteur communiquant est ainsi polyvalent et facile à utiliser.

Par ailleurs, du fait de la forme du corps du support et du positionnement du logement traversant à l'intérieur du corps, le corps entoure le module principal. En outre, le capteur communiquant, en particulier son support, est particulièrement compact.

D'autres caractéristiques optionnelles et avantageuses sont définies dans ce qui suit :
- le module principal comprend :
   ∘ une face avant, la face avant portant la surface de captage de lumière,
   ∘ une face arrière, les faces avant et arrière étant opposées et traversées par un axe de module, et
   ∘ une face périphérique, la face périphérique reliant la face arrière à la face avant et s'étendant tout autour de l'axe de module,
   l'ouverture avant, le logement traversant et l'ouverture arrière sont centrés sur un axe de corps défini par le corps du support, le logement traversant étant délimité par une paroi interne périphérique du corps, la paroi interne périphérique s'étendant tout autour de l'axe de corps, la paroi interne périphérique du corps et la face périphérique du module principal étant de formes complémentaires pour fixer le module principal au support, lorsque le module principal est logé dans le logement traversant du corps, de façon à ce que l'axe de module et l'axe de corps soient coaxiaux, lorsque le module principal est disposé selon la première orientation par rapport au support et lorsque le module principal est disposé selon la deuxième orientation par rapport au support ;
- la face périphérique du module principal présente une forme symétrique par rapport à un plan de symétrie du module principal, lequel est orthogonal avec l'axe de module et la paroi interne périphérique du corps présente une forme symétrique par rapport à un plan de symétrie du corps, lequel est orthogonal avec l'axe de corps, la face périphérique présentant, de préférence, une forme en dépression annulaire tout autour de l'axe de module, la paroi interne périphérique présentant, de préférence, une forme de col concave, autrement dit orientée vers l'extérieur, tout autour de l'axe de corps, de forme correspondante à celle de la face périphérique ;
- la face avant présente une première couleur. En outre, la face arrière présente une deuxième couleur, la deuxième couleur étant différente de la première couleur, et/ou
   la face avant présente un premier marquage et la face arrière présente un deuxième marquage, le deuxième marquage étant différent du premier marquage;
- le corps du support est formé dans un matériau élastiquement déformable, de préférence à base d'élastomère, l'ouverture avant étant conformée de sorte à ce que le module principal puisse être introduit dans le logement traversant du corps par l'intermédiaire de l'ouverture avant, par déformation élastique du corps, jusqu'à ce que le module principal soit logé dans le corps du support, quelle que ce soit la première ou la deuxième orientation du module principal par rapport au support ;
- l'ouverture avant comprend, au niveau de son pourtour, une encoche latérale, et
   le module principal comprend une languette de manipulation du module principal, la languette étant saillante par rapport au corps du support par l'intermédiaire de l'encoche latérale, lorsque le module principal est logé dans le corps du support, quelle que soit la première ou la deuxième orientation du module principal par rapport au support ;
- le corps du support comprend une zone élastique de commande ou un orifice de commande positionné entre l'ouverture avant et l'ouverture arrière, et
   le module principal comprend un bouton de commande, le bouton de commande étant configuré pour être actionné par l'intermédiaire de la zone élastique de commande ou au travers de l'orifice de commande, lorsque le module principal est logé dans le corps du support, quelle que soit la première ou la deuxième orientation du module principal par rapport au support ;
- l'élément de fixation comprend une surface adhésive, la surface adhésive s'étendant, hors du logement traversant, sur tout le pourtour de l'ouverture arrière ; et
- le module principal embarque un élément de détection de luminosité, l'élément de détection de luminosité captant la lumière incidente sur la surface de captage de lumière, l'unité électronique étant configurée pour communiquer des informations à l'unité de commande du système domotique, en fonction d'une luminosité de la lumière incidente captée par l'élément de détection de luminosité.

La présente invention vise, selon un deuxième aspect, un système domotique comprenant un capteur communiquant, conforme à l'invention et tel que mentionné ci-dessus, ainsi qu'au moins une unité de commande et au moins un ouvrant motorisé, l'ouvrant motorisé étant commandé par l'unité de commande à réception d'informations reçues du capteur communiquant via une unité électronique, les informations émises par le capteur communiquant étant dépendantes d'une luminosité de la lumière reçue sur une surface de captage de lumière.

Ce système domotique présente des caractéristiques et avantages analogues à ceux décrits précédemment, en relation avec le capteur communiquant selon l'invention.

D'autres particularités et avantages de l'invention apparaîtront encore dans la description ci-après.

Aux dessins annexés, donnés à titre d'exemples non limitatifs :
- la figure 1 est une vue en perspective d'un capteur communiquant, appartenant à un système domotique conforme à un mode de réalisation de l'invention, certains composants du système domotique étant représentés sous forme synoptique ;
- la figure 2 est une vue en perspective analogue à la figure 1, dans laquelle le capteur communiquant est représenté selon un autre angle de vue ;
- la figure 3 est une vue en perspective éclatée du capteur communiquant illustré aux figures 1 et 2 ;
- la figure 4 est une vue en perspective analogue aux figures 1 et 2, dans laquelle le capteur communiquant est représenté selon un autre angle de vue ; et
- la figure 5 est une vue en coupe transversale du capteur communiquant illustré aux figure 1 à 4, selon un plan de coupe P3 représenté à la figure 1, où le capteur communiquant est disposé en appui sur une surface de support, certains composants du capteur communiquant et du système domotique de la figure 1 étant représentés de façon synoptique sur la figure 5.

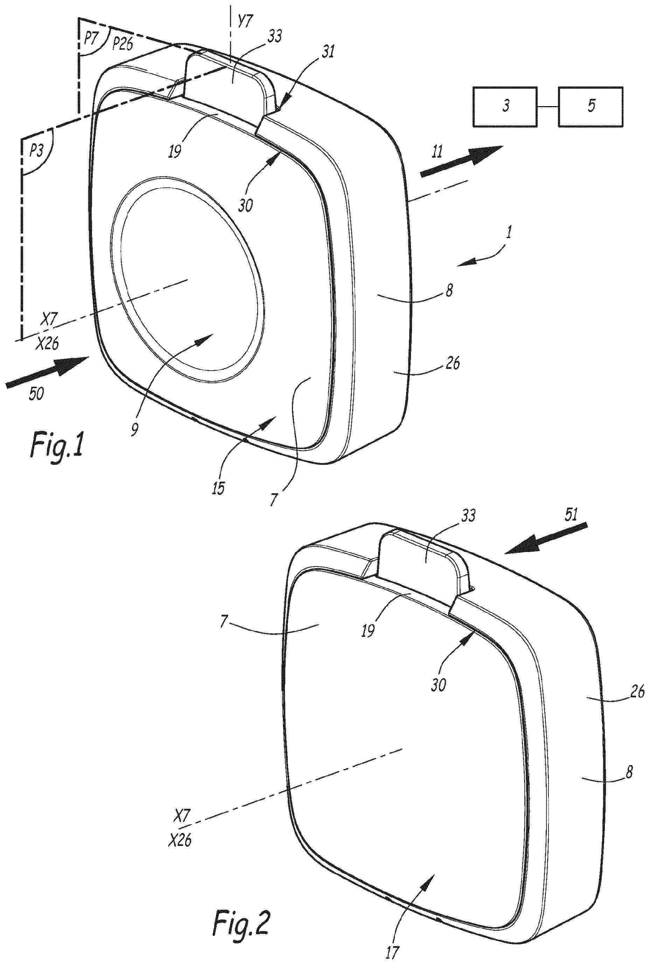

La figure 1 illustre un système domotique comprenant un capteur communiquant 1, une unité de commande 3 et un ouvrant motorisé 5, ces deux derniers objets étant représentés de façon synoptique. Par « domotique », on entend qu'il s'agit d'un système visant à automatiser certaines installations d'un bâtiment, préférentiellement au sein d'un logement, alternativement dans d'autres types de locaux, par exemple des locaux professionnels, tels que des bureaux. Un tel système domotique s'installe donc dans un bâtiment, préférentiellement une maison d'habitation.

Un ouvrant motorisé 5 est, par exemple, un store motorisé ou un volet motorisé, conçu pour obturer avec un degré variable une ouverture vitrée du bâtiment, notamment une fenêtre. L'ouvrant motorisé 5 comprend donc au moins un moteur électrique, non représenté, et au moins un écran, non représenté, tel qu'un store ou un volet, le moteur électrique entraînant l'écran entre une configuration fermée, dans laquelle l'ouverture vitrée est obturée, et une configuration ouverte, dans laquelle l'ouverture vitrée n'est pas obturée. En fonction de l'application, on peut prévoir que l'ouvrant motorisé 5 est placé à l'extérieur ou à l'intérieur du bâtiment.

L'unité de commande 3 peut être intégrée à l'ouvrant motorisé 5, en être séparée ou être commune à plusieurs ouvrants motorisés 5. En tous cas, l'unité de commande 3 est reliée au moteur électrique de l'ouvrant motorisé 5 pour commander l'actionnement du moteur électrique et ainsi entraîner l'ouverture ou la fermeture de l'écran. L'unité de commande 3 comprend, par exemple, une carte de commande, non représentée, comprenant un processeur et des composants électroniques, les composants électroniques étant contrôlés par le processeur et aptes à alimenter en énergie électrique le moteur électrique, selon un premier sens de rotation d'un arbre de sortie ou selon un deuxième sens de rotation de l'arbre de sortie, afin de déplacer l'écran entre ses configurations ouverte et fermée. Le processeur exécute, préférentiellement, un programme enregistré sur une mémoire de l'unité de commande 3. L'unité de commande 3 comprend également un dispositif de réception d'informations, notamment en provenance du capteur communiquant 1. Ce dispositif de réception d'informations est, par exemple, une partie dédiée de la carte de commande ou un récepteur sur une carte indépendante. En fonction de l'application, la transmission d'informations à partir du capteur communiquant 1 vers l'unité de commande 3 peut s'effectuer de façon filaire ou sans fil, de manière directe ou indirecte, par exemple en utilisant un autre objet communiquant, tel qu'une télécommande, une tablette, un téléphone intelligent ou un serveur. Pour toute transmission sans fil en émission ou en réception, l'unité de commande 3 est, par exemple, dotée d'une antenne. Tout protocole de transmission sans fil peut être utilisé, notamment sur la base d'ondes radio, en monodirectionnel ou en bidirectionnel. Selon l'information reçue du capteur communiquant 1, l'unité de commande 3 agit sur le moteur électrique pour déplacer l'ouvrant motorisé 5 vers une configuration ouverte ou fermée. L'unité de commande 3 peut également piloter l'écran vers une configuration intermédiaire, entre les configurations ouverte et fermée.

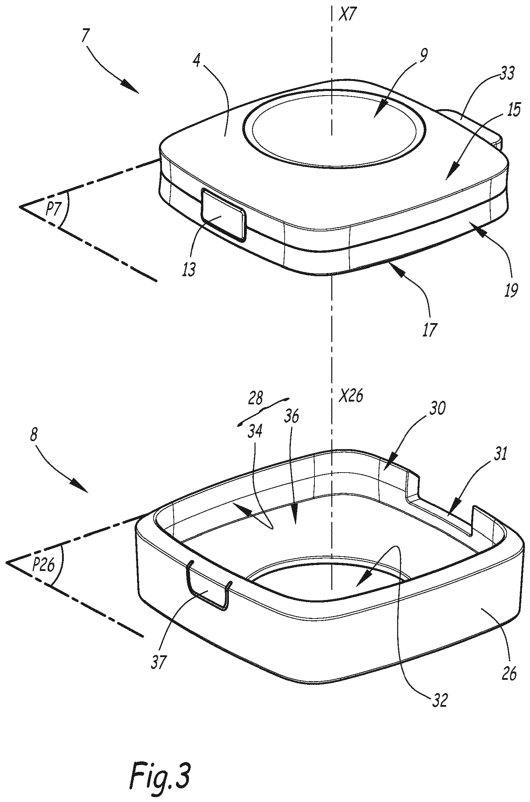

Le capteur communiquant 1 comprend un module principal 7 et un support 8, représentés ensemble sur les figures 1 et 2, dans une configuration assemblée du capteur communicant 1. Le module principal 7 et le support 8 sont représentés séparément sur la figure 3.

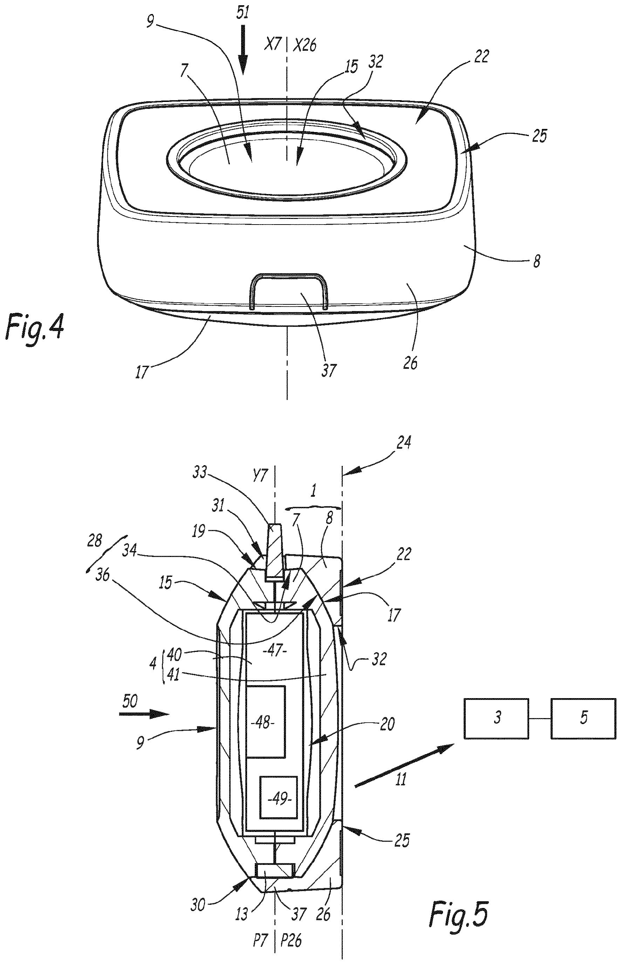

Le module principal 7 comprend un boîtier extérieur 4, au sein duquel est contenue, c'est-à-dire embarquée, une unité électronique 47 comprenant un élément de détection de luminosité 48, en particulier de type optique, comme illustré à la figure 5. L'élément de détection de luminosité 48 est, préférentiellement, un capteur de luminosité, en particulier ambiante. Ce type d'élément de détection de luminosité 48 mesure une intensité de la lumière incidente sur une surface active, par exemple la luminosité ambiante dans une pièce. L'élément de détection de luminosité 48 est, notamment, un capteur détectant la luminosité de la lumière solaire, préférentiellement dans le domaine du spectre visible.

Alternativement ou de surcroît, notamment pour d'autres types de systèmes domotiques, un autre type d'élément de détection de luminosité 48 embarqué peut être prévu. Par exemple, pour un système d'alarme ou de vidéoprotection, l'élément de détection de luminosité 48 peut être une caméra.

Quel que soit le type d'élément de détection de luminosité 48, le boîtier 4 du module principal 7 comprend une surface de captage de lumière 9. Dans le présent exemple, cette surface de captage de lumière 9 est de forme plane avec un contour circulaire. Toute autre forme pourrait convenir. Cette surface de captage de lumière 9 est donc extérieure au boîtier 4 du module principal 7. La surface de captage de lumière 9 est, notamment, visible sur les figures 1, 3, 4 et 5. C'est par l'intermédiaire et/ou au travers de cette surface de captage de lumière 9 que l'élément de détection de luminosité 48 capte la lumière nécessaire pour sa mesure. Le capteur communiquant 1 est donc configuré pour capter de la lumière sur une seule face, dite face avant 15, l'autre face opposée, dite face arrière 17, n'y étant pas sensible. L'élément de détection de luminosité 48 est, par exemple, monté sur un circuit imprimé de l'unité électronique 47 et fait face à la surface de captage de lumière 9, dans une configuration assemblée du module principal 7.

L'unité électronique 47 du module principal 7 est configurée pour communiquer à distance, en envoyant des messages ou informations 11, comme illustré à la figure 1, de façon monodirectionnelle ou bidirectionnelle, avec l'unité de commande 3 du système domotique, notamment à l'aide d'un dispositif de télécommunication 49, tel qu'un émetteur ou un émetteur-récepteur, illustré à la figure 5. Cette communication à distance est, préférentiellement, effectuée sans fil, par ondes radio ou similaire. Le contenu d'un message émis par le module principal 7 peut être une information relative à la mesure effectuée par l'élément de détection de luminosité 48 ou un message d'ordre de commande. A réception de l'information émise par le module principal 7, en fonction de son contenu, l'unité de commande 3 détermine la modification appropriée ou le maintien du degré d'obturation de l'ouvrant motorisé 5, entre la configuration ouverte ou fermée. L'ouverture et la fermeture de l'ouvrant motorisé 5 dépend donc de la luminosité mesurée par l'élément de détection de luminosité 48, c'est-à-dire l'intensité de la lumière incidente reçue sur la surface de captage de lumière 9. Plus généralement, l'ouvrant motorisé 5 est piloté par l'unité de commande 3 à réception d'informations fournies par le module principal 7 via le dispositif de télécommunication 49 de son unité électronique 47, les informations émises par le capteur communiquant 1 dépendant de la lumière reçue sur la surface de captage de lumière 9.

En variante, non représentée, la communication entre le module principal 7 et l'unité de commande 3 est effectuée de façon filaire. Dans ce dernier cas, un câble de communication relie le module principal 7 à l'unité de commande 3.

Quelle que soit la solution retenue pour le mode de télécommunication, l'unité électronique 47 du module principal 7 comprend les moyens nécessaires à cette télécommunication, par exemple une carte de télécommunication associée à une antenne, en cas de télécommunication sans fil.

L'unité électronique 47 du module principal 7 peut également embarquer un processeur, non représenté, qui reçoit des signaux électriques de la part de l'élément de détection de luminosité 48 et les convertit en informations à envoyer à l'unité de commande 3 par le biais du dispositif de télécommunication 49. L'unité électronique 47 peut être adaptée pour communiquer également avec un terminal, du genre ordiphone ou téléphone intelligent, ou tout autre moyen communiquant similaire. Par l'intermédiaire d'une application installée sur le terminal, un utilisateur peut ainsi communiquer avec le processeur embarqué du module principal 7, afin de le configurer ou de régler certains paramètres, notamment en lien avec l'élément de détection de luminosité 48. En variante, en l'absence de processeur embarqué, l'élément de détection de luminosité 48 peut fournir des informations directement au dispositif de télécommunication 49, qui les transmet à distance à l'unité de commande 3, par exemple sous forme d'une simple valeur de mesure. D'autres solutions peuvent être envisagées pour l'interaction entre l'utilisateur et le module principal 7, par exemple la présence d'un ou plusieurs boutons, ou d'autres surfaces de commande. Dans l'exemple illustré aux figures 3 et 5, le module principal 7 comprend, outre le processeur embarqué, un bouton de commande 13, par exemple de type poussoir, donnant sur l'extérieur du boîtier 4.

Le module principal 7 et, notamment, son unité électronique 47, incluant, par exemple, l'élément de détection de luminosité 48, le dispositif de télécommunication 49 et le processeur embarqué, sont, préférentiellement, alimentés en énergie électrique par une batterie, non représentée, embarquée dans le boîtier 4 du module principal 7, par exemple des piles ou une batterie rechargeable. On pourrait toutefois prévoir une alimentation en énergie électrique filaire, en particulier sur secteur, ou toute autre source d'alimentation en énergie, notamment solaire ou thermique.

Les divers systèmes électroniques et électriques, ainsi que la batterie éventuelle, sont disposés dans un logement interne 20 du boîtier 4 du module principal 7. Le logement interne 20 peut être accessible par tout moyen approprié. Par exemple, le boîtier 4 du module principal 7 peut être en deux parties 40, 41 démontables l'une par rapport à l'autre, comme représenté sur la figure 5.

Le boîtier 4 du module principal 7 comprend, sur son contour extérieur, une face avant 15, visible sur les figures 1 et 3 à 5, ainsi qu'une face arrière 17, visible sur les figures 2 et 3 et 5. Les faces avant et arrière 15, 17 sont opposées, le long d'un axe de module X7. La face avant 15 est formée sur la partie 40 du module principal 7 et la face arrière 17 est formée sur la partie 41 du module principal 7. Dans l'exemple, les faces avant et arrière 15, 17 sont orthogonales à l'axe de module X7 et traversées par cet axe de module X7 en leurs centres respectifs. La face avant 15 porte la surface de captage de lumière 9, qui est avantageusement centrée sur l'axe de module X7. Le module principal 7 comprend, en outre, une face périphérique 19, visible aux figures 3 et 5, qui relie les faces avant et arrière 15, 17 et s'étend tout autour de l'axe de module X7. La face périphérique 19 s'étend généralement de façon parallèle à l'axe de module X7. La face périphérique 19 est, avantageusement, formée en deux parties, appartenant aux parties 40, 41 du boîtier 4.

Comme montré sur les figures 1 à 5, le module principal 7 peut être logé dans le support 8 de façon à y être fixé. Toutefois, le module principal 7 est configuré pour pouvoir être séparé du support 8 par l'utilisateur, comme montré sur la figure 3, de préférence sans outil particulier.

Le support 8 comprend un corps 26, qui comprend un logement traversant 28 ménagé au travers du corps 26, comme illustré aux figures 3 et 5. Le logement traversant 28 forme une cavité débouchant de deux côtés du corps 26, pour loger le module principal 7. Le logement traversant 28 débouche d'un côté du corps 26 en formant une ouverture avant 30, visible sur les figures 1, 2, 3 et 5. Le logement traversant 28 débouche d'un autre côté du corps 26 en formant une ouverture arrière 32, visible sur les figures 3 à 5. Les ouvertures avant et arrière 30, 32 sont disposées et tournées à l'opposé l'une de l'autre, à deux extrémités opposées du corps 26. Le logement traversant 28, ainsi que les ouvertures avant et arrière 30, 32, sont centrés sur un axe de corps X26 et l'entourent, en étant répartis le long de cet axe de corps X26. De préférence, le corps 26 entoure toute la circonférence du logement traversant 28 autour de l'axe de corps X26. Le corps 26 présente ainsi une forme générale annulaire.

Le long de l'axe de corps X26, le corps 26 comprend successivement une paroi interne périphérique 34 et une paroi interne arrière 36, qui délimitent le logement traversant 28, comme illustré aux figures 3 et 5. Le long de l'axe de corps X26, la paroi interne périphérique 34 débute à l'ouverture avant 30 et se termine à la paroi interne arrière 36. La paroi interne arrière 36 débute à la paroi interne périphérique 34 et se termine à l'ouverture arrière 32. Les parois interne périphérique et interne arrière 34, 36 s'étendent chacune tout autour de l'axe de corps X26.

Comme montré sur les figures 4 et 5, le support 8 comprend une surface adhésive 22, qui sert d'élément de fixation du support 8 contre une surface de support 24. La surface adhésive 22 est disposée sur une face d'appui 25 du corps 26, qui entoure l'ouverture arrière 32 à l'extérieur du logement traversant 28. La surface adhésive 22 étant, avantageusement, répartie sur tout le pourtour de l'ouverture arrière 32, son collage contre la surface de support 24 est, particulièrement, résistant, bien que le capteur communiquant 1 soit compact. La surface adhésive 22 est solidaire, c'est-à-dire fixée, au corps 26. De préférence, la surface adhésive 22 s'étend dans un plan orthogonal à l'axe de corps X26, tout comme la face d'appui 25, également appelée arrière, du corps 26.

Pour la fixation du support 8, toute surface de support 24 du bâtiment, d'aire suffisante, convient.

On peut prévoir que cette surface de support 24 est celle d'un objet opaque, tel qu'un mur extérieur ou intérieur du bâtiment, une cloison du bâtiment ou une paroi d'un élément de mobilier disposé dans le bâtiment. Alternativement, cette surface de support 24 est une surface translucide, telle qu'une vitre d'une fenêtre, d'une porte-fenêtre ou d'une baie vitrée, donnant avantageusement sur l'extérieur du bâtiment.

Avantageusement, la surface adhésive 22, éventuellement repositionnable, présente des les propriétés collantes permettant une fixation par collage du support 8, aussi bien sur une surface de support 24 du genre mur ou sur une surface de support 24 du genre vitre. La fixation est alors avantageusement effectuée sans perçage ou altération significative de la surface de support 24. Alternativement ou conjointement à la surface adhésive 22, on peut prévoir un système de ventouse, d'aimants ou tout autre moyen de fixation approprié du support 8 contre la surface de support 24, éventuellement en coopération avec des moyens correspondants positionnés sur la surface de support 24. Quel que soit le moyen de fixation du support 8, ce moyen est avantageusement réparti tout autour de l'ouverture arrière 32, afin d'offrir une surface de fixation maximale.

Avantageusement, la surface de support 24 est verticale ou, éventuellement, légèrement inclinée par rapport à la verticale, pour des raisons d'orientation du capteur communiquant 1 par rapport à la source de lumière que l'élément de détection de luminosité 48 doit capter.

De préférence, cette surface de support 24 est plane. En variante, non représentée, la surface de support 24 peut être incurvée, en particulier dans le cas où le capteur communiquant 1 est monté sur un pot de fleur, en particulier de section circulaire, ou tout autre objet présentant une surface courbe.

Selon un autre exemple de réalisation, la face arrière 25 du corps 26 du support 8 peut également être incurvée, de façon concave ou convexe, ou présenter tout profil géométrique pour s'adapter à la forme de la surface de support 24. On choisit, par exemple, que la face arrière 25 présente une forme complémentaire à celle de la surface de support 24, par exemple une forme courbée. La face arrière 25 peut suivre un même profil géométrique, ou un profil géométrique proche, de celui de la surface de support 24.

Selon un autre exemple de réalisation, la surface adhésive 22 est conçue pour absorber un profil géométrique non plan de la surface de support 24, en particulier courbe, alors que la face arrière 25 du corps 26 du support 8 présente un profil géométrique différent, par exemple un profil géométrique plan.

Lorsque le support 8 est fixé sur la surface de support 24, comme montré sur la figure 5, cette surface de support 24 obture, préférentiellement, l'ouverture arrière 32 du support 8, du fait de l'orientation de l'ouverture arrière 32 vers l'arrière du capteur communiquant 1, c'est-à-dire à l'opposé de l'ouverture avant 30 du support 8. L'élément de fixation 22 du support 8 est disposé du côté de l'ouverture arrière 32, pour que l'ouverture arrière 32 soit disposée contre la surface de support 24, c'est-à-dire que celle-ci débouche sur la surface de support 24. Dans le présent exemple, l'ouverture arrière 32 est pour cela délimitée par l'intersection du logement traversant 28 et de la face arrière 25 du corps 26 portant la surface adhésive 22. La surface adhésive 22 se trouvant interposée entre le corps 26 et la surface de support 24, lorsque le support 8 est fixé à la surface de support 24. L'ouverture arrière 32 débouche alors sur la surface de support 24. Lorsque la surface 24 est celle d'une vitre ou tout objet translucide, la lumière peut toutefois atteindre et traverser l'ouverture arrière 32 au travers de la vitre. Lorsque la surface de support 24 est celle d'un mur ou tout objet opaque, l'ouverture arrière 32 est cachée de la lumière.

Le logement traversant 28 du corps 26 et le module principal 7 sont configurés pour que le module principal 7 puisse être logé alternativement selon deux orientations distinctes dans le support 8.

Le module principal 7 peut être logé dans le support 8 selon une orientation directe, autrement dit première orientation, qui est celle montrée sur les figures 1 et 5, et selon une orientation indirecte, autrement dit deuxième orientation, qui est celle montrée sur les figures 2 et 4. Dans ces deux orientations, les axes de module X7 et de corps X26 sont, avantageusement, coaxiaux. Les orientations directe et indirecte sont opposées. Dans le présent exemple, en orientation directe, le module principal 7 est pivoté à 180° (degrés) autour d'un axe Y7, orthogonal à l'axe de module X7, par rapport à l'orientation indirecte. Ce sont, notamment, la forme extérieure du module principal 7 et celle du logement traversant 28 qui permettent au module principal 7 d'adopter ces deux orientations.

L'utilisateur peut choisir quelle orientation adopter, selon si la surface de support 24 est transparente ou non, et selon la direction de provenance de la lumière à capter par la surface de captage de lumière 9. En effet, compte-tenu des caractéristiques géométriques du capteur communiquant 1 et des deux ouvertures avant et arrière 30, 32, le module principal 7 est fonctionnel dans les deux orientations.

Dans l'orientation directe présentée sur les figures 1 et 5, la surface de captage de lumière 9 du module principal 7 et la face avant 15 du module principal 7 sont encadrées par l'ouverture avant 30 du support 8. La surface de captage de lumière 9 est laissée essentiellement ou totalement libre et non recouverte par l'ouverture avant 30. De la lumière peut être reçue sur la surface de captage de lumière 9 via l'ouverture avant 30. La face arrière 17 du module principal 7 obture alors avantageusement l'ouverture arrière 32 du support 8.

L'orientation directe permet de capter de la lumière orientée selon une flèche 50 montrée sur les figures 1 et 5. Comme montré par la flèche 50, la lumière est orientée en direction de l'ouverture avant 30 et atteint ainsi la surface de captage de lumière 9.

Dans l'orientation indirecte présentée sur les figures 2 et 4, la surface de captage de lumière 9 du module principal 7 est encadrée par l'ouverture arrière 32 du support 8. La surface de captage de lumière 9 est laissée essentiellement ou totalement libre et non recouverte par l'ouverture arrière 32. De la lumière peut être reçue sur la surface de captage de lumière 9 via l'ouverture arrière 32, au travers de la surface de support 24. La surface de support 24 doit alors être translucide ou transparente pour permettre à de la lumière d'être captée par la surface de captage de lumière 9 au travers de la surface de support 24. La face arrière 17 du module principal 7 obture alors avantageusement l'ouverture avant 30 du support 8.

L'orientation indirecte permet de capter de la lumière orientée selon une flèche 51 montrée sur les figures 2 et 4. Comme montré par la flèche 51, la lumière est orientée en direction de l'ouverture arrière 32 et atteint ainsi la surface de captage de lumière 9.

Quelle que soit l'orientation choisie, le module principal 7 est maintenu radialement par rapport à l'axe de module X7 par le logement traversant 28 du support 8. En particulier, pour cela, la face périphérique 19 du module principal 7 coopère mécaniquement avec la paroi interne périphérique 34 du support 8, dans une configuration assemblée du capteur communiquant 1. La paroi périphérique interne 34 du support 8 est, optionnellement, dans un matériau plus dur ou plus résistant que le matériau utilisé pour le reste du corps 26 du support 8. La paroi interne périphérique 34 du support 8 et la face périphérique 19 du module principal 7 sont de formes complémentaires, pour fixer le module principal 7 au corps 26 du support 8, lorsque le module principal 7 est logé dans le logement traversant 28 du support 8. De façon préférentielle, la face périphérique 19 du module principal 7 présente une forme symétrique par rapport à un plan P7 du module principal 7, lequel est orthogonal avec l'axe de module X7. Le plan P7 est, par exemple, un plan de joint des deux parties 40, 41 du module principal 7. Ici, le plan P7 est donc un plan de symétrie. La paroi interne périphérique 34 du support 8 présente aussi une forme symétrique par rapport à un plan de symétrie P26 du corps 26. Le plan de symétrie P26 est confondu avec le plan P7, lorsque le module principal 7 est monté dans le logement traversant 28 du support 8. Le plan de symétrie P26 est orthogonal avec l'axe de corps X26. Dans le présent exemple, le boîtier 4 du module principal 7, et même tout le module principal 7, en ce qui concerne son extérieur, présente une forme symétrique par rapport au plan P7, orthogonal à l'axe de module X7. De préférence, les parties 40, 41 du module principal 7 sont identiques, de façon à pouvoir être obtenues par moulage dans un même moule.

Du fait de la symétrie des faces 15, 17, 19 et des parois 19, 34 respectives du module principal 7 et du corps 26 du support 8 en coopération dans le logement traversant 28 du support 8, dans la configuration assemblée du capteur communiquant 1, les deux orientations directe et indirecte susmentionnées peuvent être adoptées, le module principal 7 étant reçu et fixé dans le corps 26 du support 8 indifféremment dans les deux orientations. Cela pourrait être obtenu sans symétrie, à condition que les faces 15, 17, 19 du module principal 7 et que les parois internes 34, 36 du corps 26 du support 8, de part et d'autre du plan P7, soient compatibles entre elles pour coopérer pour les deux orientations du module principal 7, dans la configuration assemblée du capteur communiquant 1. Par exemple, les faces avant et arrière 15, 17 sont, préférentiellement, de formes similaires ou identiques l'une par rapport à l'autre, en étant tournées à l'opposé l'une de l'autre.

Dans l'exemple des figures 3 et 5, la face périphérique 19 du module principal 7 présente une forme en dépression annulaire, tout autour de l'axe de module X7. En d'autres termes, la face périphérique 19 présente une réduction de section en partie centrale ou est concave. Pour obtenir cette forme en dépression annuaire, chaque partie 40, 41 présente une dépouille vis-à-vis de l'axe de module X7, comme montré sur les figures 3 et 5, ou un chanfrein. La combinaison des deux surfaces formées par les parties 40, 41 en dépouille ou en chanfrein forme la face périphérique 19, en obtenant ainsi la forme en dépression annulaire. La paroi interne périphérique 34 du support 8 présente réciproquement une forme convexe, c'est-à-dire une forme saillante vers l'intérieur du logement traversant 28, tout autour de l'axe de corps X26. La forme convexe de la paroi interne périphérique 34 du support 8 est complémentaire de celle de la face périphérique 19 du module principal 7. Ces formes préférentielles permettent une fixation du module principal 7 par rapport au support 8, parallèlement aux axes de module X7 et de corps X26. D'autres formes peuvent également être envisagées pour obtenir une fixation axiale et radiale du module principal 7 dans le corps 26 du support 8.

Avantageusement, en orientation directe, la face arrière 17 du module principal 7 et la paroi interne arrière 36 du support 8 sont conformées pour une mise en appui, dans la configuration assemblée du capteur communiquant 1. Ce qui renforce le maintien axial du module principal 7 dans le corps 26 du support 8. En orientation indirecte, c'est la face avant 15 du module principal 7 et la paroi interne arrière 36 du support 8 qui sont conformées pour une mise en appui, dans la configuration assemblée du capteur communiquant 1. Ce qui renforce le maintien axial du module principal 7 dans le corps 26 du support 8.

En résumé, lorsque le module principal 7 est monté dans le logement traversant 28 du support 8, le module principal 7 est maintenu fixe par rapport au corps 26 du support 8. Toute autre coopération mécanique appropriée entre le boîtier 4 du module principal 7 et le corps 26 du support 8 peuvent permettre d'obtenir un même positionnement relatif et amovible du module principal 7 et du support 8.

De façon préférentielle, le corps 26 du support 8 est formé dans une matière plastique. Plus généralement, le corps 26 est, avantageusement, formé dans un matériau élastiquement déformable, en particulier à la main. Lorsque ce matériau est une matière plastique, on choisit, de préférence, un matériau à base d'élastomère. En variante, le corps 26 peut être dans une autre matière plastique qui présente des caractéristiques d'élasticité permettant un encliquetage élastique ou encore un maintien par adhérence du module principal 7 à l'intérieur du support 8. Dans un autre exemple de réalisation, le corps 26 peut également comprendre au moins un élément de fixation permettant de maintenir le module principal 7 par rapport au support 8, en particulier un élément de fixation par encliquetage élastique.

De préférence, l'ouverture avant 30 du support 8 est conformée pour que le module principal 7 puisse être introduit dans le logement traversant 28 du support 8 par l'intermédiaire de l'ouverture avant 30, axialement le long de l'axe de corps X26, jusqu'à ce que le module principal 7 soit logé dans le logement traversant 28 du support 8, quelle que soit l'orientation directe ou indirecte du module principal 7 par rapport au support 8. Cette introduction ne peut, avantageusement, pas être faite au travers de l'ouverture arrière 32 du support 8, plus petite que l'ouverture avant 30 du support 8, pour garantir plus de stabilité du module principal 7 logé dans le corps 26 du support 8, dans la configuration assemblée du capteur communiquant 1. L'introduction du module principal 7 par l'utilisateur dans le logement traversant 28 du support 8 entraîne une déformation élastique du corps 26 du support 8, agrandissant l'ouverture avant 30 du support 8 pour permettre le passage du module principal 7 et pour permettre l'engagement de la paroi interne périphérique 34 du support 8 avec la face périphérique 19 du module principal 7 et ainsi fixer le module principal 7 dans le logement traversant 28 du support 8.

De manière avantageuse, la face avant 15 du module principal 7 présente une première couleur, par exemple blanche, et la face arrière 17 du module principal 7 présente une deuxième couleur, par exemple noire, qui peut être distinguée à l'œil nu de la première couleur. Ainsi, même si les faces avant et arrière 15, 17 présentent exactement la même forme, comme c'est le cas sur la figure 5, un utilisateur peut savoir facilement selon quelle orientation le module principal 7 est logé dans le corps 26 du support 8. En effet, l'ouverture avant 30 du support 8 est suffisamment grande pour laisser apparaître une partie de la face avant 15 du module principal 7, en orientation directe, et de la face arrière 17 du module principal 7, en orientation indirecte. La couleur de la face avant 15 ou arrière 17 visible renseigne alors l'utilisateur sur l'orientation du module principal 7 par rapport au support 8.

En variante, non représentée, la différenciation entre la face avant 15 et la face arrière 17 du module principal 7 peut être mise en œuvre par un marquage sur chacune des faces avant 15 et arrière 17. Plus précisément, dans cette variante, la face avant 15 présente extérieurement un premier marquage et la face arrière 17 présente un deuxième marquage, le premier marquage et le deuxième marquage pouvant être distingués à l'œil nu. Les deux marquages sont différents. Ces marquages peuvent être obtenus, par exemple, au cours du moulage, dans le cas où les parties 40, 41 du boîtier 4 du module principal 7 sont obtenues par moulage. Alternativement, ces marquages peuvent être obtenus par une tampographie sur chacune des faces avant 15 et arrière 17 ou par un état de surface sur chacune des faces avant 15 et arrière 17, notamment lors du moulage des parties 40, 41 du boîtier 4 du module principal 7.

Les deux marquages et les deux couleurs décrits ci-dessus peuvent être mis en œuvre en simultanément ou alternativement.

Alternativement ou de surcroît, comme montré sur les figures 1 et 2, la face avant 15 du module principal 7 peut présenter un aspect différent de celui de la face arrière 17 du module principal 7, du fait de la présence de la surface de captage de lumière 9 sur la face avant 15, alors que la face arrière 17 ne présente pas d'élément particulier en surface. Dans ce cas, les faces avant et arrière 15, 17 peuvent être différenciées grâce à leur géométrie.

De préférence, l'ouverture avant 30 du support 8 comprend, sur son pourtour, une encoche latérale 31. Cette encoche latérale 31 débute au contour de l'ouverture avant 30 et s'étend parallèlement à l'axe de module X26 en direction de l'ouverture arrière 32. Le module principal 7 comprend une languette 33 de manipulation du module principal 7. La languette 33 est, avantageusement, saillante de la face périphérique 19 du module principal 7, en s'étendant selon le plan P7. La languette 33 s'étend sur une portion seulement du périmètre de la face périphérique 19 autour de l'axe de module X7. Comme montré sur les figures 1 à 3 et 5, quelle que soit l'orientation directe ou indirecte du module 7 principal dans le logement traversant 28 du support 8, la languette 33 est saillante au travers du corps 26 du support 8 par l'intermédiaire de l'encoche latérale 31 du support 8, lorsque le module principal 7 est logé dans le logement traversant 28 du support 8. Cette languette 33 sert, d'une part, à la fois de moyen de manipulation pour extraire le module principal 7 par rapport au logement traversant 28 du support 8, contre l'élasticité du corps 26 du support 8, et, d'autre part, de moyen de détrompage en rotation autour de l'axe de module X7. En effet, pour l'insertion du module principal 7 dans le logement traversant 28 du support 8, la languette 33 du module principal 7 est nécessairement alignée avec l'encoche latérale 31 du support 8.

Comme visible sur les figures 3 et 4, le corps 26 du support 8 comprend une zone élastique d'appui 37. Cette zone élastique d'appui 37 est positionnée sur la portion du corps 26 du support 8 reliant les ouvertures avant et arrière 30, 32 du support 8, par exemple de façon diamétralement opposée autour de l'axe de corps X26 par rapport à l'encoche latérale 31 du support 8. Le bouton de commande 13 du module principal 7 est apte à être actionné par l'intermédiaire de la zone élastique d'appui 37, lorsque le module principal 7 est logé dans le logement traversant 28 du support 8, la zone élastique d'appui 37 s'étendant jusqu'à l'intérieur du logement traversant 28. L'utilisateur appuie sur la zone élastique d'appui 37 à partir de l'extérieur du support 8, de sorte à déplacer la zone élastique d'appui 37 en direction de l'axe de corps X26. Ce qui pousse alors le bouton de commande 13 du module principal 7, dans la configuration assemblée du capteur communiquant 1. Le bouton de commande 13 du module principal 7 et la zone élastique d'appui 37 du support 8 sont disposés de façon à être superposés, dans la configuration assemblée du capteur communiquant 1, pour permettre un tel fonctionnement, que le module principal 7 soit en orientation directe ou en orientation indirecte par rapport au support 8. Pour cela, le bouton de commande 13 du module principal 7 est, avantageusement, positionné dans le plan P7, ainsi que la zone élastique d'appui 37 du support 8. Par ailleurs, lorsqu'un détrompage en rotation est prévu, par exemple avec la languette 33 du module principal 7 et l'encoche latérale 31 du support 8, cela permet d'assurer que le module principal 7 est inséré dans une bonne orientation par rapport au support 8, autour de l'axe de corps X26, pour que cette superposition du bouton de commande 13 du module principal 7 et de la zone élastique d'appui 37 du support 8 soit obtenue, dans la configuration assemblée du capteur communiquant 1. L'utilisateur peut donc actionner le bouton de commande 13 du module principal 7 même lorsque le module principal 7 est contenu dans le support 8.

En variante, non représentée, la zone élastique d'appui 37 du support 8 peut être remplacée par un simple orifice de commande traversant, débouchant dans le logement traversant 28 du support 8, pour que le bouton de commande 13 du module principal 7 puisse être actionné au travers de cet orifice traversant.

De manière avantageuse, le module principal 7 peut comporter, en outre, un témoin lumineux de fonctionnement, non représenté, par exemple une diode électroluminescente, disposée dans le boîtier 4 du module principal 7. Par exemple, le témoin lumineux de fonctionnement s'allume lorsque l'unité électronique 47 du module principal 7 est active ou a émis une information à destination de l'unité de commande 3, en particulier avec succès. Le témoin lumineux de fonctionnement peut également s'allumer à certains moments prédéterminés du fonctionnement du module principal 7. De préférence, le boîtier 4 du module principal 7 est suffisamment opaque pour qu'un utilisateur ne puisse pas voir son contenu, lorsque le témoin lumineux de fonctionnement est éteint, tout en étant suffisamment translucide pour que l'utilisateur puisse voir la lumière du témoin lumineux de fonctionnement au travers du boîtier 4, lorsque le témoin lumineux de fonctionnement est allumé. Alternativement, une ouverture est prévue dans le boîtier 4 du module principal 7, recouverte ou non, d'une plaque translucide, pour la visibilité du témoin lumineux de fonctionnement. Une seule diode électroluminescente peut être utilisée pour éclairer sur les deux faces avant et arrière 15, 17 opposées du boîtier 4 du module principal 7.

De nombreuses modifications peuvent être apportées aux exemples de réalisation décrits précédemment sans sortir du cadre de l'invention.

En outre, les modes de réalisation et variantes envisagés peuvent être combinés pour générer de nouveaux modes de réalisation de l'invention.

## Revendications

1. Capteur communiquant (1) pour un système domotique, le capteur communiquant (1) comprenant un module principal (7) présentant extérieurement une surface de captage de lumière (9) et embarquant une unité électronique (47), l'unité électronique (47) étant configurée pour communiquer à distance avec une unité de commande (3) du système domotique,
**caractérisé en ce que** le capteur communiquant (1) comprend, en outre, un support (8), le support (8) étant séparable du module principal (7) et comprenant :
- un élément de fixation (22) du support (8) contre une surface de support (24), et
- un corps (26), le corps (26) étant solidaire de l'élément de fixation (22), le corps (26) comprenant un logement traversant (28), une ouverture avant (30) et une ouverture arrière (32), chacune des ouvertures avant (30) et arrière (32) débouchant du corps (26), à l'opposé l'une de l'autre par rapport au logement traversant (28) ménagé à l'intérieur du corps (26), l'élément de fixation (22) étant disposé du côté de l'ouverture arrière (32), le logement traversant (28) logeant le module principal (7) alternativement selon deux orientations :
∘ une première orientation, dans laquelle la surface de captage de lumière (9) est encadrée par l'ouverture avant (30), pour recevoir de la lumière au travers de l'ouverture avant (30), et
∘ une deuxième orientation, opposée à la première orientation, dans laquelle la surface de captage de lumière (9) est encadrée par l'ouverture arrière (32), pour recevoir de la lumière au travers de l'ouverture arrière (32).

2. Capteur communiquant (1) pour un système domotique selon la revendication 1, **caractérisé en ce que** :
- le module principal (7) comprend :
∘ une face avant (15), la face avant (15) portant la surface de captage de lumière (9),
∘ une face arrière (17), les faces avant (15) et arrière (17) étant opposées et traversées par un axe de module (X7), et
∘ une face périphérique (19), la face périphérique (19) reliant la face arrière (17) à la face avant (15) et s'étendant tout autour de l'axe de module (X7),
- l'ouverture avant (30), le logement traversant (28) et l'ouverture arrière (32) sont centrés sur un axe de corps (X26) défini par le corps (26) du support (8), le logement traversant (28) étant délimité par une paroi interne périphérique (34) du corps (26), la paroi interne périphérique (34) s'étendant tout autour de l'axe de corps (X26), la paroi interne périphérique (34) du corps (26) et la face périphérique (19) du module principal (7) étant de formes complémentaires pour fixer le module principal (7) au support (8), lorsque le module principal (7) est logé dans le logement traversant (28) du corps (26), de façon à ce que l'axe de module (X7) et l'axe de corps (X26) soient coaxiaux, lorsque le module principal (7) est disposé selon la première orientation par rapport au support (8) et lorsque le module principal (7) est disposé selon la deuxième orientation par rapport au support (8).

3. Capteur communiquant (1) pour un système domotique selon la revendication 2, **caractérisé en ce que** :
- la face périphérique (19) du module principal (7) présente une forme symétrique par rapport à un plan de symétrie (P7) du module principal (7), lequel est orthogonal avec l'axe de module (X7), et
- la paroi interne périphérique (34) du corps (26) présente une forme symétrique par rapport à un plan de symétrie (P26) du corps (26), lequel est orthogonal avec l'axe de corps (X26).

4. Capteur communiquant (1) pour un système domotique selon la revendication 2 ou selon la revendication 3, **caractérisé en ce que** :
- la face avant (15) présente une première couleur et la face arrière (17) présente une deuxième couleur, la deuxième couleur étant différente de la première couleur, et/ou
- la face avant (15) présente un premier marquage et la face arrière (17) présente un deuxième marquage, le deuxième marquage étant différent du premier marquage.

5. Capteur communiquant (1) pour un système domotique selon l'une quelconque des revendications 1 à 4, **caractérisé en ce que** le corps (26) du support (8) est formé dans un matériau élastiquement déformable, l'ouverture avant (30) étant conformée de sorte à ce que le module principal (7) puisse être introduit dans le logement traversant (28) du corps (26) par l'intermédiaire de l'ouverture avant (30), par déformation élastique du corps (26), jusqu'à ce que le module principal (7) soit logé dans le corps (26) du support (8), quelle que soit la première ou la deuxième orientation du module principal (7) par rapport au support (8).

6. Capteur communiquant (1) pour un système domotique selon l'une quelconque des revendications 1 à 5, **caractérisé en ce que** :
- l'ouverture avant (30) comprend, au niveau de son pourtour, une encoche latérale (31), et
- le module principal (7) comprend une languette (33) de manipulation du module principal (7), la languette (33) étant saillante par rapport au corps (26) du support (8) par l'intermédiaire de l'encoche latérale (31), lorsque le module principal (7) est logé dans le corps (26) du support (8), quelle que soit la première ou la deuxième orientation du module principal (7) par rapport au support (8).

7. Capteur communiquant (1) pour un système domotique selon l'une quelconque des revendications 1 à 6, **caractérisé en ce que** :
- le corps (26) comprend une zone élastique de commande (37) ou un orifice de commande positionné entre l'ouverture avant (30) et l'ouverture arrière (32), et
- le module principal (7) comprend un bouton de commande (13), le bouton de commande (13) étant configuré pour être actionné par l'intermédiaire de la zone élastique de commande (37) ou au travers de l'orifice de commande, lorsque le module principal (7) est logé dans le corps (26) du support (8), quelle que soit la première ou la deuxième orientation du module principal (7) par rapport au support (8).

8. Capteur communiquant (1) pour un système domotique selon l'une quelconque des revendications 1 à 7, **caractérisé en ce que** l'élément de fixation (22) comprend une surface adhésive, la surface adhésive s'étendant, hors du logement traversant (28), sur tout le pourtour de l'ouverture arrière (32).

9. Capteur communiquant (1) pour un système domotique selon l'une quelconque des revendications 1 à 8, **caractérisé en ce que** le module principal (7) embarque un élément de détection de luminosité (48), l'élément de détection de luminosité (48) captant la lumière incidente sur la surface de captage de lumière (9), l'unité électronique (47) étant configurée pour communiquer des informations (11) à l'unité de commande (3) du système domotique, en fonction d'une luminosité de la lumière incidente captée par l'élément de détection de luminosité (48).

10. Système domotique comprenant un capteur communiquant (1) selon l'une quelconque des revendications 1 à 9, ainsi qu'au moins une unité de commande (3) et au moins un ouvrant motorisé (5), l'ouvrant motorisé (5) étant commandé par l'unité de commande (3) à réception d'informations (11) reçues du capteur communiquant (1) via une unité électronique (47), les informations (11) émises par le capteur communiquant (1) étant dépendantes d'une luminosité de la lumière incidente reçue sur une surface de captage de lumière (9).

## Patentansprüche

1. Kommunizierender Sensor (1) für ein Hausautomatisierungssystem, der kommunizierende Sensor (1) umfassend ein Hauptmodul (7), das außen eine Lichtsammelfläche (9) aufweist und eine elektronische Einheit (47) trägt, wobei die elektronische Einheit (47) konfiguriert ist, um in einer Entfernung mit einer Steuereinheit (3) des Hausautomatisierungssystems zu kommunizieren,
**dadurch gekennzeichnet, dass** der kommunizierende Sensor (1) ferner einen Träger (8) umfasst, wobei der Träger (8) von dem Hauptmodul (7) trennbar ist und Folgendes umfasst:
- ein Befestigungselement (22) des Trägers (8) an einer Trägerfläche (24), und
- einen Körper (26), wobei der Körper (26) fest mit dem Befestigungselement (22) verbunden ist, der Körper (26) umfassend eine durchgehende Aufnahme (28), eine vordere Öffnung (30) und eine hintere Öffnung (32), wobei jede von der vorderen (30) und der hinteren (32) Öffnung zu dem Körper (26) hin offen sind, in Bezug auf die durchgehende Aufnahme (28) einander gegenüber im Innern des Körpers (26) eingerichtet sind, wobei das Befestigungselement (22) auf der Seite der hinteren Öffnung (32) angeordnet, wobei die durchgehende Aufnahme (28) das Hauptmodul (7) abwechselnd in zwei Ausrichtungen aufnimmt:
∘ eine erste Ausrichtung, in der die Lichtsammelfläche (9) von der vorderen Öffnung (30) eingerahmt ist, um Licht durch die vordere Öffnung (30) zu erhalten, und
∘ eine zweite Ausrichtung entgegengesetzt zu der ersten Ausrichtung, in der die Lichtsammelfläche (9) von der hinteren Öffnung (32) eingerahmt ist, um Licht durch die hintere Öffnung (32) zu erhalten.

2. Kommunizierender Sensor (1) für ein Hausautomatisierungssystem nach Anspruch 1, **dadurch gekennzeichnet, dass**:
- das Hauptmodul (7) Folgendes umfasst:
∘ eine Vorderseite (15), wobei die Vorderseite (15) die Lichtsammelfläche (9) trägt,
∘ eine Rückseite (17), wobei die Vorder- (15) und die Rückseite (17) einander gegenüber sind und von einer Modulachse (X7) durchquert werden, und
∘ eine Umfangsfläche (19), wobei die Umfangsfläche (19) die hintere Fläche (17) mit der vorderen Fläche (15) verbindet und sich um die Modulachse (X7) erstreckt,
- die vordere Öffnung (30), die durchgehende Aufnahme (28) und die hintere Öffnung (32) auf einer Körperachse (X26) zentriert sind, die durch den Körper (26) des Trägers (8) definiert ist, wobei die durchgehende Aufnahme (28) durch eine periphere Innenwand (34) des Körpers (26) begrenzt ist, sich die periphere Innenwand (34) um die Körperachse (X26) erstreckt, wobei die periphere Innenwand (34) des Körpers (26) und die periphere Fläche (19) des Hauptmoduls (7) komplementäre Formen sind, um das Hauptmodul (7) an dem Träger (8) zu befestigen, wenn das Hauptmodul (7) in der durchgehenden Aufnahme (28) des Körpers (26) aufgenommen ist, sodass die Modulachse (X7) und die Körperachse (X26) koaxial sind, wenn das Hauptmodul (7) in der ersten Ausrichtung in Bezug auf den Träger (8) angeordnet ist und wenn das Hauptmodul (7) in der zweiten Ausrichtung in Bezug auf den Träger (8) angeordnet ist.

3. Kommunizierender Sensor (1) für ein Hausautomatisierungssystem nach Anspruch 2, **dadurch gekennzeichnet, dass**:
- die periphere Fläche (19) des Hauptmoduls (7) eine symmetrische Form in Bezug auf eine Symmetrieebene (P7) des Hauptmoduls (7) aufweist, die orthogonal zu der Modulachse (X7) ist, und
- die periphere Innenwand (34) des Körpers (26) eine symmetrische Form in Bezug auf eine Symmetrieebene (P26) des Körpers (26) aufweist, die orthogonal zu der Körperachse (X26) ist.

4. Kommunizierender Sensor (1) für ein Hausautomatisierungssystem nach Anspruch 2 oder Anspruch 3, **dadurch gekennzeichnet, dass**:
- die Vorderseite (15) eine erste Farbe aufweist und die Rückseite (17) eine zweite Farbe aufweist, wobei sich die zweite Farbe von der ersten Farbe unterscheidet, und/oder
- die Vorderseite (15) eine erste Markierung aufweist und die Rückseite (17) eine zweite Markierung aufweist, wobei sich die zweite Markierung von der ersten Markierung unterscheidet.

5. Kommunizierender Sensor (1) für ein Hausautomatisierungssystem nach einem der Ansprüche 1 bis 4, **dadurch gekennzeichnet, dass** der Körper (26) des Trägers (8) aus einem elastisch verformbaren Material gebildet ist, wobei die vordere Öffnung (30) geformt ist, sodass das Hauptmodul (7) über die vordere Öffnung (30) in die durchgehende Aufnahme (28) des Körpers (26) eingeführt werden kann, durch elastische Verformung des Körpers (26), bis das Hauptmodul (7) in dem Körper (26) des Trägers (8) aufgenommen ist, unabhängig von der ersten oder zweiten Ausrichtung des Hauptmoduls (7) in Bezug auf dem Träger (8).

6. Kommunizierender Sensor (1) für ein Hausautomatisierungssystem nach einem der Ansprüche 1 bis 5, **dadurch gekennzeichnet, dass**:
- die vordere Öffnung (30) an ihrem Umfang eine seitliche Kerbe (31) aufweist, und
- das Hauptmodul (7) eine Zunge (33) zur Handhabung des Hauptmoduls (7) umfasst, wobei die Zunge (33) über die seitliche Kerbe (31) aus dem Körper (26) des Trägers (8) hervorsteht, wenn das Hauptmodul (7) in dem Körper (26) des Trägers (8) aufgenommen ist, unabhängig von der ersten oder der zweiten Ausrichtung des Hauptmoduls (7) in Bezug auf den Träger (8).

7. Kommunizierender Sensor (1) für ein Hausautomatisierungssystem nach einem der Ansprüche 1 bis 6, **dadurch gekennzeichnet, dass**:
- der Körper (26) einen elastischen Steuerbereich (37) oder eine Steueröffnung aufweist, die zwischen der vorderen Öffnung (30) und der hinteren Öffnung (32) positioniert ist, und
- das Hauptmodul (7) einen Steuerknopf (13) umfasst, wobei der Steuerknopf (13) konfiguriert ist, um über den elastischen Steuerbereich (37) oder über die Steueröffnung betätigt zu werden, wenn das Hauptmodul (7) in dem Körper (26) des Trägers (8) aufgenommen ist, unabhängig von der ersten oder der zweiten Ausrichtung des Hauptmoduls (7) in Bezug auf den Träger (8).

8. Kommunizierender Sensor (1) für ein Hausautomatisierungssystem nach einem der Ansprüche 1 bis 7, **dadurch gekennzeichnet, dass** das Befestigungselement (22) eine Klebefläche umfasst, wobei sich die Klebefläche rund um die hintere Öffnung (32) aus der durchgehenden Aufnahme (28) erstreckt.

9. Kommunizierender Sensor (1) für ein Hausautomatisierungssystem nach einem der Ansprüche 1 bis 8, **dadurch gekennzeichnet, dass** das Hauptmodul (7) ein Helligkeitserfassungselement (48) enthält, wobei das Helligkeitserfassungselement (48) das auf die Lichterfassungsfläche (9) auftreffende Licht erfasst, wobei die elektronische Einheit (47) konfiguriert ist, um der Steuereinheit (3) des Hausautomatisierungssystems Informationen (11) in Abhängigkeit von der Helligkeit des einfallenden Lichts zu übermitteln, das von dem Helligkeitserfassungselement (48) erfasst wird.

10. Hausautomatisierungssystem, umfassend einen kommunizierenden Sensor (1) nach einem der Ansprüche 1 bis 9 sowie mindestens eine Steuereinheit (3) und mindestens einen motorisierten Flügel (5), wobei der motorisierte Flügel (5) bei Empfang von Informationen (11), die von dem kommunizierenden Sensor (1) über eine elektronische Einheit (47) empfangen werden, von der Steuereinheit (3) gesteuert wird, wobei die von dem kommunizierenden Sensor (1) übertragenen Informationen (11) von einer Helligkeit des einfallenden Lichts abhängig sind, das auf einer Lichtsammelfläche (9) empfangen wird.

## Claims

1. - A communicating sensor (1) for a home automation system, the communicating sensor (1) comprising a main module (7) externally having a light-sensing surface (9) and carrying an electronic unit (47), the electronic unit (47) being configured to communicate remotely with a control unit (3) of the home automation system,
**characterised in that** the communicating sensor (1) further comprises a support (8), the support (8) being separable from the main module (7) and comprising:
- a fastening element (22) of the support (8) against a support surface (24), and
- a body (26), the body (26) being integral with the fastener (22), the body (26) comprising a through-hole (28), a front opening (30) and a rear opening (32), both the front (30) and rear (32) openings being open into the body (26) opposite each other with respect to the through-hole (28) provided inside the body (26), the fastening element (22) being disposed on the side of the rear opening (32), the through-hole (28) housing the main module (7) alternately in two orientations:
∘ a first orientation, in which the light-sensing surface (9) is framed by the front aperture (30), for receiving light through the front aperture (30), and
∘ a second orientation, opposite to the first orientation, in which the light-sensing surface (9) is framed by the rear aperture (32), for receiving light through the rear aperture (32).

2. - The communicating sensor (1) for a home automation system according to claim 1, **characterised in that**:
- the main module (7) comprises:
∘ a front face (15), the front face (15) carrying the light-sensing surface (9),
∘ a rear face (17), the front (15) and rear (17) faces being opposite each other and having a module axis (X7) passing through them, and
∘ a peripheral face (19), the peripheral face (19) connecting the rear face (17) to the front face (15) and extending around the module axis (X7),
- the front opening (30), the through-hole (28) and the rear opening (32) are centred on a body axis (X26) defined by the body (26) of the support (8), the through-hole (28) being bounded by a peripheral inner wall (34) of the body (26) the peripheral inner wall (34) extending around the body axis (X26), the peripheral inner wall (34) of the body (26) and the peripheral face (19) of the main module (7) being of complementary shapes to secure the main module (7) to the support (8), when the main module (7) is received in the through-hole (28) of the body (26), such that the module axis (X7) and the body axis (X26) are coaxial, when the main module (7) is arranged in the first orientation relative to the support (8) and when the main module (7) is arranged in the second orientation relative to the support (8).

3. - The communicating sensor (1) for a home automation system according to claim 2, **characterised in that**:
- the peripheral face (19) of the main module (7) has a symmetrical shape with respect to a plane of symmetry (P7) of the main module (7), which is orthogonal to the module axis (X7), and
- the peripheral inner wall (34) of the body (26) has a symmetrical shape with respect to a plane of symmetry (P26) of the body (26), which is orthogonal with the body axis (X26).

4. - The communicating sensor (1) for a home automation system according to claim 2 or claim 3, **characterised in that**:
- the front face (15) has a first colour and the rear face (17) has a second colour, the second colour being different from the first colour, and/or
- the front face (15) has a first marking and the rear face (17) has a second marking, the second marking being different from the first marking.

5. - The communicating sensor (1) for a home automation system according to any of claims 1 to 4, **characterised in that** the body (26) of the support (8) is formed from an resiliently deformable material, the front opening (30) being shaped so that the main module (7) can be inserted into the through-hole (28) of the body (26) via the front opening (30), by resilient deformation of the body (26) until the main module (7) is received in the body (26) of the support (8), irrespective of the first or second orientation of the main module (7) relative to the support (8).

6. - The communicating sensor (1) for a home automation system according to any of claims 1 to 5, **characterised in that**:
- the front opening (30) comprises a lateral notch (31) at its perimeter, and
- the main module (7) comprises a tongue (33) for handling the main module (7), the tongue (33) protruding from the body (26) of the support (8) via the lateral notch (31), when the main module (7) is housed in the body (26) of the support (8), regardless of the first or second orientation of the main module (7) with respect to the support (8).

7. - The communicating sensor (1) for a home automation system according to any of claims 1 to 6, **characterised in that**:
- the body (26) comprises a resilient control area (37) or control port positioned between the front opening (30) and the rear opening (32), and
- the main module (7) comprises a control knob (13), the control knob (13) being configured to be operated via the resilient control area (37) or through the control port, when the main module (7) is housed in the body (26) of the support (8), irrespective of the first or second orientation of the main module (7) relative to the support (8).

8. - The communicating sensor (1) for a home automation system according to any one of claims 1 to 7, **characterised in that** the fastening element (22) comprises an adhesive surface, the adhesive surface extending out of the through-hole (28) all around the rear opening (32).

9. - The communicating sensor (1) for a home automation system according to any one of claims 1 to 8, **characterised in that** the main module (7) contains a brightness detection element (48), the brightness detection element (48) sensing the incident light on the light sensing surface (9), the electronic unit (47) being configured to communicate information (11) to the control unit (3) of the home automation system, depending on a brightness of the incident light sensed by the brightness sensing element (48).

10. - A home automation system comprising a communicating sensor (1) according to any one of claims 1 to 9, as well as at least one control unit (3) and at least one motorised door (5), the motorised door (5) being controlled by the control unit (3) on receipt of information (11) received from the communicating sensor (1) via an electronic unit (47), the information (11) transmitted by the communicating sensor (1) being dependent on a brightness of the incident light received on a light-sensing surface (9).
